# EUROPEAN PATENT APPLICATION

(11) **EP 3 569 370 A1**
(43) Date of publication of application: **20.11.2019**
(21) Application number: 18173328.8
(22) Date of filing: 18.05.2018
(51) Int. Cl.: B25J 15/06, H05K 3/34, B23K 1/00, B23K 3/08, B23K 37/04, B23K 3/047, B23K 20/16

(54) **DEVICE FOR GRIPPING AND WELDING ELECTRONIC COMPONENTS AND ASSOCIATED ACTUATING HEAD, ROBOT AND METHOD**

(71) Applicant: SUPSI (Scuola Universitaria Professionale Della Svizzera Italiana), 6928 Manno (CH)
(72) Inventor: Valente, Anna, 6984 Pura (CH); Brugnetti, Ivan, 6983 Magliaso (CH); Colla, Marco, 6600 Muralto (CH)
(74) Representative: Pasquino, Fabio

(57) **Abstract**

A device (100) for gripping and welding electronic components (1) of the Chip-On-Carrier type on a support, comprising first suction means able, during use, to retain the electronic component (1) and defining a first gripping area (111) for the electronic component (1), second suction means (122) able, during use, to retain a sheet (2) of welding material and defining a second gripping area (121), the second suction means (122) are disposed outside the first gripping area (111) of the electronic component (1), and welding means (130) of the sheet (2) of welding material, able, during use, to deliver an electrical impulse for melting the sheet (2) of welding material.

The first gripping area (111) of the electronic component (1) and the second gripping area (121) of the sheet (2) of welding material are arranged on different and parallel planes, and the second suction means are movable between a gripping position (GP), retaining the sheet (2) of welding material spaced from the electronic component (1), and a welding position (WP), retaining the sheet (2) of welding material at the support and in contact with the electronic component (1) held by the first suction means during the delivery of the electrical impulse from the welding means (130).

## Description

### Field of invention

The present invention relates to the field of robotics devices and to the manipulation of Chip-On-Carrier (COC) components. In particular, the present invention relates to a device for gripping and welding electronic components of the COC type on the relative support, or substrate.

In a further aspect, the present invention relates to an actuating head for gripping and welding electronic components of the COC type for a robotic arm.

Still in a further aspect, the present invention relates to a robot for gripping and welding electronic components of the COC type.

Finally, in a further aspect, the present invention relates to a method for gripping and welding electronic components of the COC type.

### Background art

Modern electronic circuits employ discrete and non-discrete electronic components of the surface mount type. These electronic components are known by the acronym SMD.

In particular, with regard to the power chips and semiconductors, these are supplied on special supports called carriers (Chip-On-Carrier) which must be coupled, or welded, on a substrate, often constituted directly by the final package, with appropriate positioning and welding specifications (for example, relating to temperature and pressure). A particular coupling technology uses "*reactive*" welding elements, in particular of reactive multilayer sheet or reactive multilayer nanosheet material. These can be realized, for example, by thin layers of welding material interposed between layers of a particular reactive material and are activated by means of energy induction - typically electric - which generates localized heating sufficient to realize the melting of the welding material, with the consequent coupling of the electronic component on its support.

The miniaturization of electronic components and welding elements, such as chips and nanosheets, makes their handling extremely difficult due to the small dimensions to be managed and the particular sensitivity to static electricity. The manual manipulation, in fact, makes this last drawback particularly important as the human being often accumulates sufficient static electricity to damage the electronic component during its handling. Moreover, due to the aforementioned miniaturization, the positioning of the electronic components and welding elements with the precision required by the specifications of the final product is difficult to achieve with manual assembly, or at least requires an assembly time implying long times and high costs.

There is, therefore, the need for a device and a method for gripping and welding electronic components, in particular COC, which allows their fast, precise and reliable manipulation and welding on the relative substrate (or support), thus competing to solve the above-described drawbacks.

### Summary of the Invention

The object of the present invention is to provide a device for gripping and welding for electronic components of the COC type on a support capable of minimizing the aforementioned drawbacks.

According to the present invention, therefore, a device for gripping and welding electronic components according to the appended claims is described. The device for gripping and welding comprises first suction means able, during use, to retain the electronic component and defining a first gripping area for the electronic component, second suction means able, during use, to retain a sheet of welding material and defining a second gripping area, the second suction means being disposed outside the first gripping area of the electronic component, and welding means of the sheet of welding material, able, during use, to deliver an electrical impulse for melting the sheet of welding material; wherein the first gripping area of the electronic component and the second gripping area of the sheet of welding material are arranged on different and parallel planes, and wherein the second suction means are movable between a gripping position, wherein they retain the sheet of welding material spaced from the electronic component retained by the first suction means, and a welding position, wherein they retain the sheet of welding material at the support and in contact with the electronic component held by the first suction means during the delivery of the electrical impulse from the welding means.

The above-mentioned device therefore enables automatic welding of electronic components onto a substrate by using a sheet of welding material to be interposed therebetween.

Preferably, the welding means are interposed between the first suction means and the second suction means, when the second suction means are arranged in the gripping position.

Therefore, both the electronic component and the sheet of welding material are not in contact with the welding means during handling, eliminating the risk of accidental damage.

Preferably, the device comprises a support element of the electronic component, wherein the first suction means are arranged in the support element in such a way as to define a cavity able to house a portion of the electronic component not in contact with the first suction means. Even more preferably, the support element is provided with at least a pair of side walls extending on planes orthogonal to the first gripping area of the electronic component, the pair of side walls is able to at least partially delimit the first gripping area for the electronic component support.

The support element allows to improve the handling of the electronic component and to accurately collect and arrange it in the desired position.

Preferably, the first suction means comprise a plurality of first suction ducts and the second suction means comprise a plurality of second suction ducts. Even more preferably, the plurality of first suction ducts is arranged in a symmetrical configuration with respect to a symmetry axis of the first gripping area and the plurality of second suction ducts is arranged symmetrically with respect to a symmetry axis of the second gripping area.

The plurality of ducts used and their arrangement allows to improve the grip of the electronic component and of the sheet of welding material, minimizing the portion of the gripping area in which to arrange the aforesaid suction means.

Preferably, the device comprises elastic means operatively connected to the plurality of second suction ducts for moving the plurality of second suction ducts between the gripping position and the welding position, and vice versa, wherein the elastic means are pre-tensioned to maintain the second suction ducts in the gripping position and allowing the second suction ducts to be placed in the welding position when the second ducts are subjected to a pressure on a support.

The use of the elastic means allows to easily achieve the desired effect related to the handling of the second suction means. Moreover, their pre-tensioning allows to obtain the desired pressure of the electronic component and of the sheet of welding material on the substrate, as well as the desired pressure of the welding means on the sheet of welding material.

Preferably, the first suction means and the second suction means are connected to a single suction fitting. Alternatively, the first suction means are connected to a first suction fitting and the second suction means are connected to a second suction fitting independent from the first suction fitting.

The use of a single duct, while limiting the versatility of the device, allows to limit the production and operating costs of the same, in particular during the gripping and retaining phases.

The aforementioned object is further achieved by an actuating head for gripping and welding electronic components of the COC type according to the appended claims. The actuating head comprises a device for gripping and welding electronic components of the Chip-On-Carrier type on a support as described above, and an interface device provided with a coupling flange for the robotic arm and able to operatively connect the device for gripping and welding to the robotic arm; the device for gripping and welding comprises at least a first mechanical interface pin and at least a first electrical interface pin, and the interface device comprises at least a first mechanical interface connector, able to couple with the first mechanical interface pin, and at least a first electrical interface connector, able to couple with the first electric interface pin for feeding the welding means; wherein the first mechanical interface pin and the first mechanical interface connector respectively have a through opening which, when coupled, defines a first air duct for feeding the first suction means and/or the second suction means, and wherein the interface device comprises a control unit provided with at least one capacitor for the energy storage for activating the welding means of device for gripping and welding. Even more preferably, the device for gripping and welding comprises a first mechanical interface pin and a second mechanical interface pin, the interface device comprises a first mechanical interface connector and a second mechanical interface connector, wherein the first pin of the mechanical interface and the first mechanical interface connector respectively have a through opening which, when coupled, defines a first air duct for feeding the first suction means, and wherein the second mechanical interface pin and the second mechanical connector respectively have a through opening which, when coupled, defines a second air duct for feeding the second suction means.

The use of an actuating head of the aforesaid type allows to handle in an automatic manner the device for gripping and welding, as well as to obtain a high flexibility in the use of different devices for gripping and welding as a function of conformation of the elements to be moved and/or the process to be carried out. In addition, the use of hollow mechanical interface connectors reduces costs and setup times of the actuating head.

Preferably, the interface device comprises compressed air feeding means and at least one Venturi device, operatively connected to the compressed air feeding means and to the first suction means and/or the second suction means, to obtain suction force to the first suction means and/or to the second suction means through the feeding of compressed air into the Venturi device.

Preferably, the first mechanical interface connector and/or the second mechanical interface connector are actuatable between an operating position, wherein are respectively coupled to the first mechanical interface pin and/or to the second mechanical interface pin, and a resting position, wherein are respectively decoupled from the first mechanical interface pin and/or from the second mechanical interface pin, and wherein the interface device comprises an electric motor operatively connected to the first mechanical interface connector and/or the second mechanical interface connector to modify the mutual distance between said first connector and said second mechanical interface connector.

In this way, it is possible to achieve different spacings between the two connectors in order to obtain the coupling between the interface device and a plurality of different devices for gripping and welding.

Again, the aforementioned object is achieved by a robot for gripping and welding electronic components of the COC type according to the appended claims. The robot comprises an actuating head for gripping and welding electronic components of the Chip-On-Carrier type on a support as described above, a robotic arm provided with an end comprising a housing flange for the coupling flange and a computerized and programmable data processing unit able to control the movement of the robotic arm and/or of the actuating head for gripping and welding; wherein the data processing unit is able to control the control unit of the interface device for actuating the welding means of the device for gripping and welding.

Finally, the aforementioned object is achieved by a method for gripping and welding electronic components of the COC type according to the appended claims. The method comprises the steps of withdrawing and retaining the electronic component within a first gripping area, by means of first suction means; withdrawing and retaining a sheet of welding material within a second gripping area, by means of second suction means, wherein the sheet of welding material is arranged in a gripping position spaced from the electronic component; arranging the electronic component and the sheet of welding material at a support of the electronic component while maintaining the retention of the electronic component and of the sheet of welding material; depositing the sheet of welding material in a welding position, by moving the second suction means, in which the sheet of welding material is arranged on the support in contact with the electronic component retained by the first suction means; welding the electronic component on the support by melting the sheet of welding material, by means of welding means able to deliver an electrical impulse for melting the sheet of welding material, exerting a predetermined pressure of the electronic component and of the sheet of welding material on the support; and release the electronic component and the sheet of welding material coupled on the support.

### Description of the figures

These and further features and advantages of the present invention will become apparent from the disclosure of the preferred embodiment, illustrated by way of a non-limiting example in the accompanying figures, wherein:
- Figure 1 shows a perspective view of a portion of the device for gripping and welding, according to the present invention;
- Figure 1A shows the device for gripping and welding of Figure 1, wherein the first gripping area and the second gripping area are represented;
- Figure 2 shows a front sectional view of the portion of the device for gripping and welding of Figure 1;
- Figure 3 shows a side sectional view of the portion of the device for gripping and welding of Figure 1;

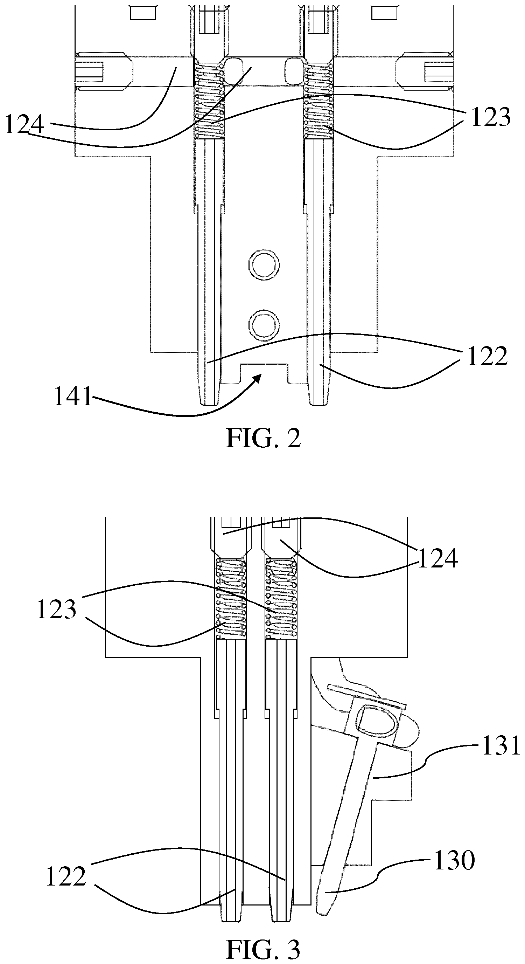

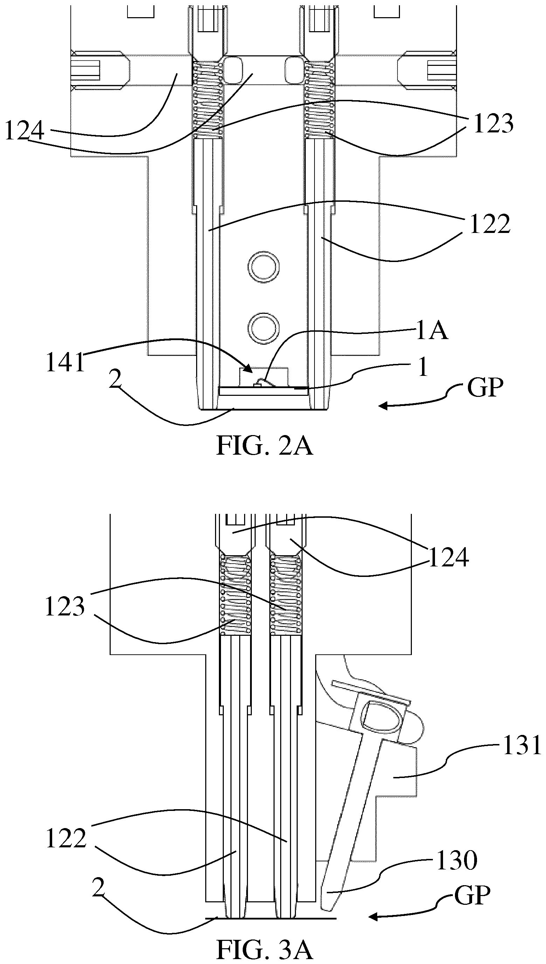

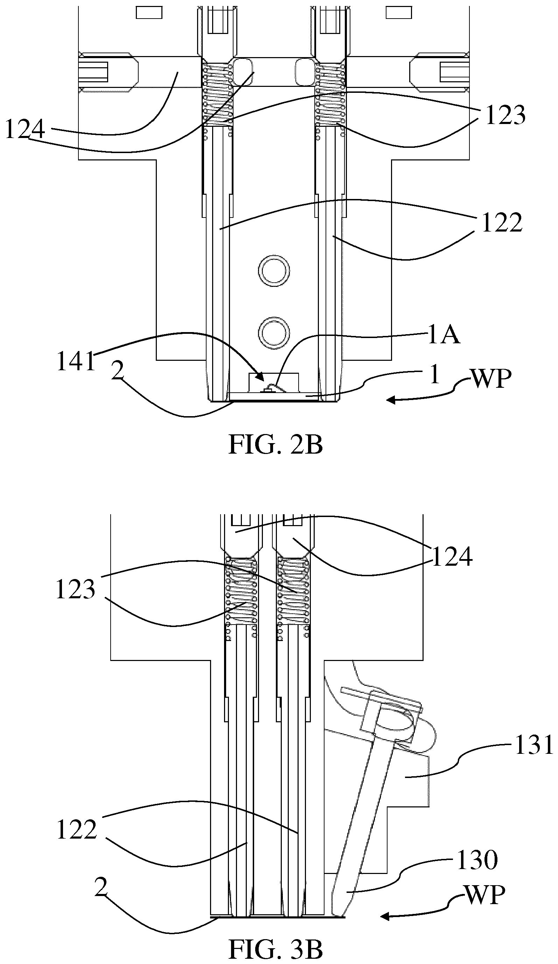

- Figures 2A and 3A show respectively Figures 2 and 3, when the second suction means are in the gripping position;
- Figures 2B and 3B show respectively Figures 2 and 3, when the second suction means are in the welding position;

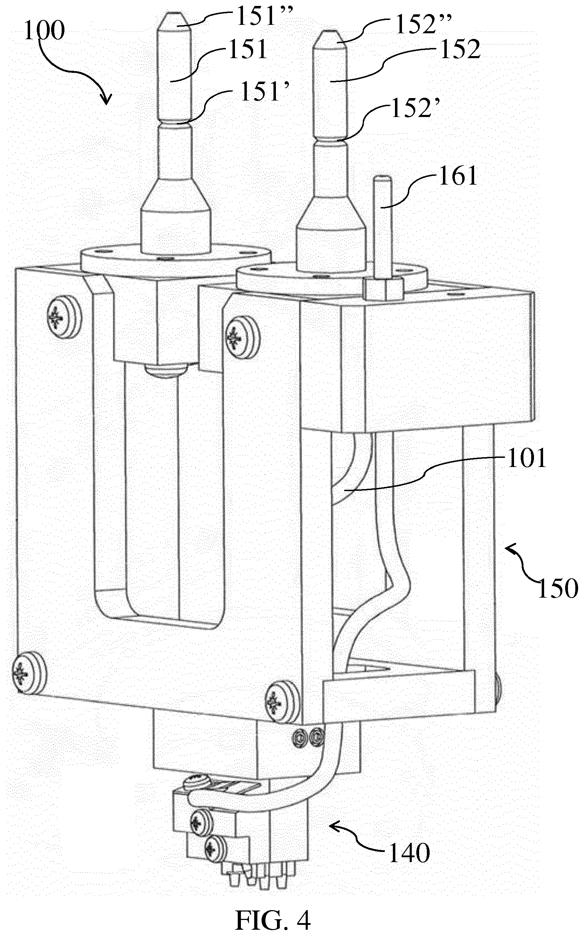

- Figure 4 shows a perspective view of the device for gripping and welding, according to the present invention;

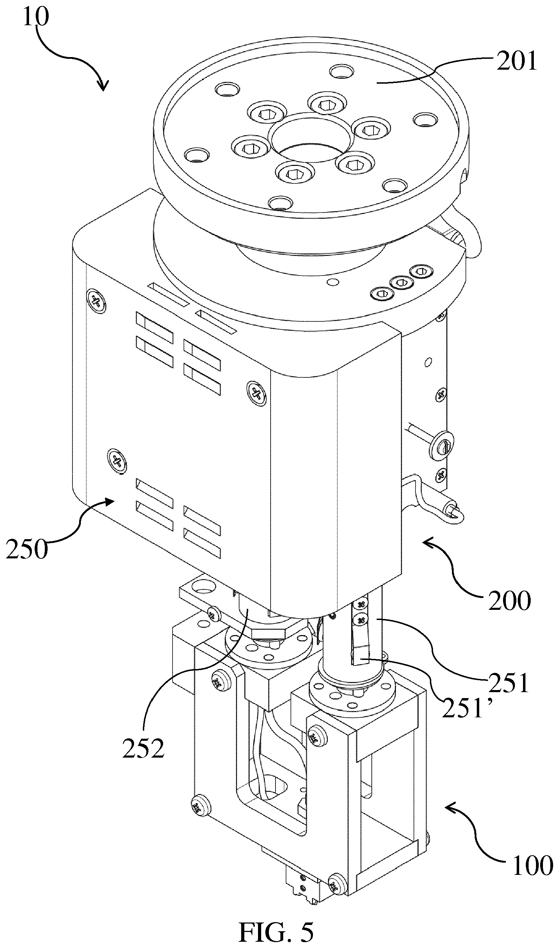

- Figure 5 shows a perspective view of the actuating head comprising the device for gripping and welding, according to the present invention;

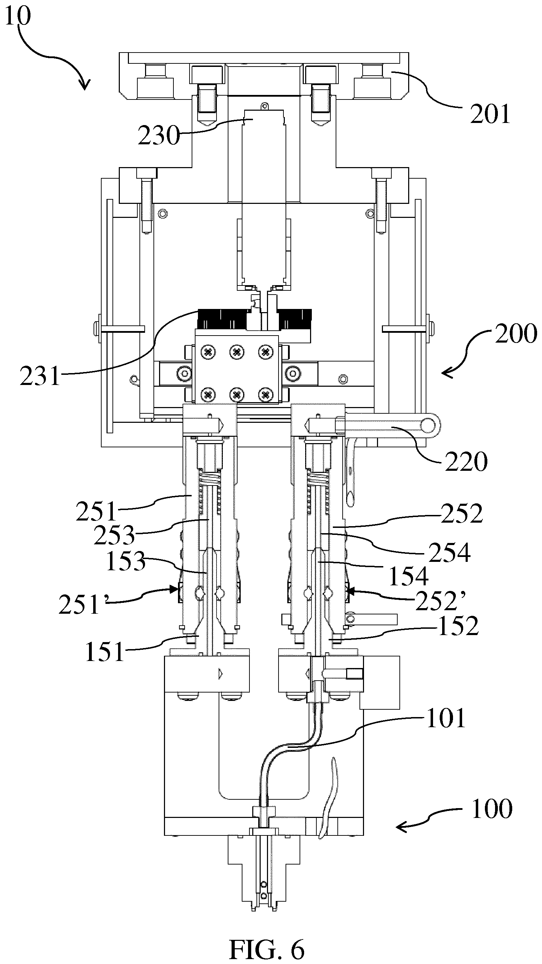

- Figure 6 shows a front plan view in section of the actuating head of Figure 5.

### Detailed description of the invention

The present invention relates to a device for gripping and welding electronic components, in particular specifically designed to allow the collecting and subsequent welding of electronic components 1. This device for gripping and welding is able to be coupled to a robotic arm (not shown), for example by means of an actuating head for gripping and welding.

The device for gripping and welding is also designed to move a sheet 2 of welding material, able to be melted by localized heating together with the moved electronic component 1. In particular, the aforementioned sheet 2 of welding material can comprise a multilayer sheet defined by a metallic material to be welded and a reactive material capable of reaching very high localized temperatures, even in the 1500°C range, when activated by an electric impulse.

The device for gripping and welding according to the present invention allows, for example, to assemble electronic components 1, such as chips and semiconductors of the Chip-On-Carrier type (COC), on suitable substrates. The coupling between the electronic component 1 and its substrate (not shown) is obtained by welding, or melting, the sheet 2 of welding material on a hypothetical welding plane, defined by the upper surface of the substrate on which it is to be coupled the electronic component 1.

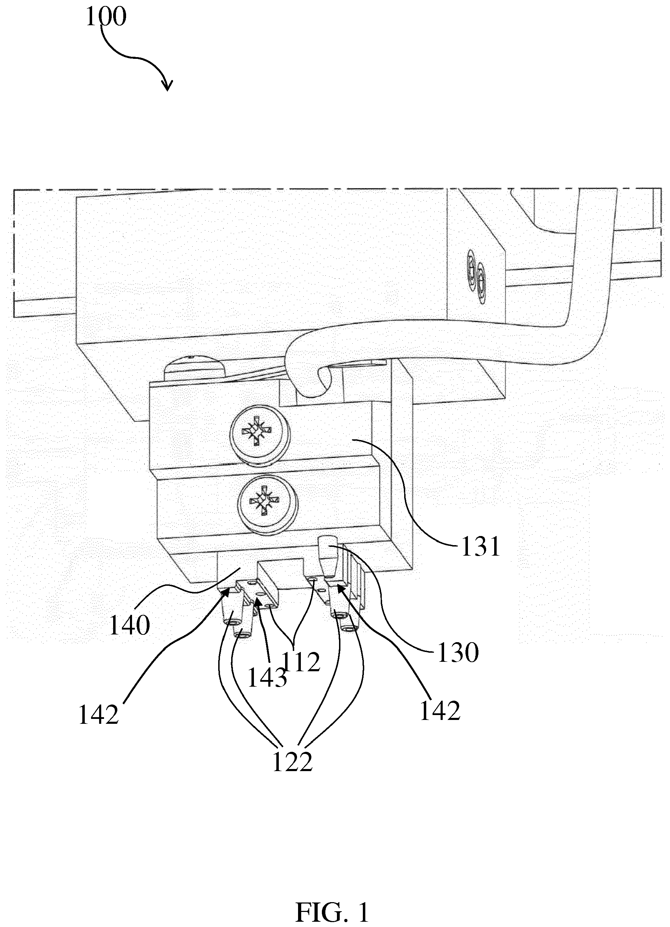

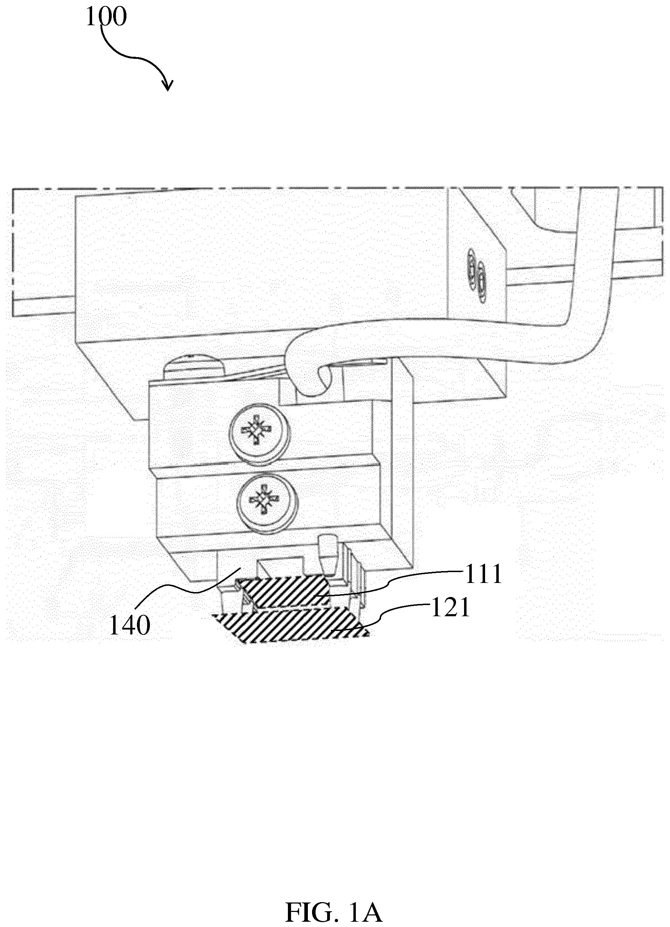

Figures 1 and 1A show, in a portion thereof, the device 100 for gripping and welding electronic components 1, according to the present invention. In particular, the illustrated portion can define an exhaustive embodiment of the aforesaid device, while excluding the components designed for join with an interface device for coupling to an actuating head, as illustrated in Figure 4 and described in detail in the following.

The device 100 for gripping and welding according to the present invention comprises first suction means able, during use, to retain the electronic component 1, which defines a first gripping area 111 thereof. The device 100 for gripping and welding is further provided with second suction means able, during use, to retain the sheet 2 of welding material, which defines a second gripping area 121 thereof. The first gripping area 111 of the electronic component 1 and the second gripping area 121 of the sheet 2 of welding material are arranged on different and parallel planes. Moreover, the second suction means are arranged outside the first gripping area 111, i.e. the orthogonal projection of the second suction means on the welding plane is arranged outside the same orthogonal projection of the first gripping area 111. Accordingly, the second gripping area 121 defined by the second suction means has a greater size than the first gripping area 111 defined by the first suction means. Further, the second gripping area 121 is arranged at a shorter distance from the welding plane (not shown) with respect to the aforesaid first gripping area 111, thereby allowing the sheet 2 of welding material to always be in a position below the electronic component 1 to allow welding with respect to the entire area occupied by the electronic component 1 on the relative substrate. The shorter distance from the welding plane of the second gripping area 121 with respect to the first gripping area 111 is obtained as a consequence of the arrangement of the respective suction means, i.e. the second suction means are arranged at a smaller distance from the welding plane with respect to the first suction means.

The term "*gripping area*" means, in the present invention, the area within which respectively the electronic component 1 and the sheet 2 of welding material are retained by the device 100 for gripping and retaining. In particular, in the present invention the term "*gripping area*" identifies the area within which respectively the first suction means or the second suction means define their operation and, therefore, retaining area. The gripping area does not necessarily or exclusively correspond to a surface of the aforementioned device 100, or a component thereof. In fact, as illustrated in Figure 1A, the gripping area 111, 121 underlies a portion of the device 100 only at the respective first and second suction means, being otherwise extended on a hypothetical plane contiguous to the surface of the terminal portion of the aforesaid first and second suction means. Thus, the gripping area 111, 121 is an area within which respectively the electronic component 1 or the sheet 2 of welding material are retained by the device 100 for gripping and welding and at least partially in contact respectively with the first or second suction means.

In Figure 1A, the aforementioned first gripping area 111 and second gripping area 121 are illustrated in relation to the portion of the device 100 for gripping and welding illustrated in Figure 1. In the embodiment illustrated in Figure 1A, the first gripping area 111 has a non-concentric arrangement with respect to the second gripping area 121. Preferably, the first gripping area 111 has a perimeter side superimposable to the second gripping area 121, defining an alignment between the electronic component and the sheet of welding material with respect to the aligned side. In particular, the first gripping area 111 has an extension lower than the second gripping area 121.

Furthermore, it is possible that the aforesaid alignment is carried out on several perimeter sides of the first gripping area superimposable on the same sides of the second gripping area.

In a further embodiment, not shown, the first gripping area and the second gripping area may be concentric with each other, preferably with the first gripping area having a lower extension and therefore entirely superimposable on the second gripping area.

The second suction means, shown in the sectional representations of Figures 2, 2A, 2B, 3, 3A, 3B and described in greater detail below, are movable between two different positions, in particular between a gripping position GP and a welding position WP, and vice versa. In the gripping position GP, shown in Figures 2A and 3A, the second suction means retain the sheet 2 of welding material spaced from the electronic component 1 retained by the first suction means. In the welding position WP, shown in Figures 2B and 3B, the second suction means retain the sheet 2 of welding material in contact with the electronic component 1 retained by the first suction means until the welding is completed. Hence, the second suction means are of the movable type and, consequently, define a second gripping area 121 of the movable type according to the aforementioned displacements between the gripping position GP and the welding position WP, and vice versa. Moreover, the second gripping area 121 is arranged at a shorter distance from the welding plane with respect to the aforesaid first gripping area 111, both when the second suction means are arranged at the gripping position GP and when the second suction means are arranged at the welding position WP.

The aforesaid device 100 is completed by suitable welding means 130 for welding the sheet 2, able to deliver, during use, an electrical impulse for melting the sheet 2 of welding material. Preferably, the aforementioned welding means 130 consist of a welding tip electrically connected to an actuating circuit, which is reset in a predetermined reset time. Such reset time is between 40" and 60" but can vary, for example reduced by increasing the quantity of charging current of the capacitor. In order to realize the electrical isolation of the terminal portion of the device 100 for gripping and welding with respect to the remaining part, an insulating element 131 allows electrically decoupling the welding tip 130, that in the embodiment shown in Figure 3 crosses the aforesaid insulating element 131. Therefore, the electrical decoupling allows to separate the welding tip 130 from the portion of the device 100 for gripping and welding at the first gripping area 111 and at the second gripping area 121, for example at a support element 140 as in the following description.

The welding means 130, or the relative welding tip, has an arrangement which is interposed between the first suction means and the second suction means, when the second suction means are arranged in the aforementioned gripping position GP. In this way, during the gripping of the electronic component 1 and of the sheet 2 of welding material, the welding means 130 are not as physically in contact as they are electrically connected with the aforesaid elements 1 and 2. Furthermore, the welding means 130, or the relative welding tip, are arranged outside the first gripping area 111 of the electronic component 1, as previously described for the second suction means. In this way, the welding tip 130 is in contact, or at a distance such as to allow the electric impulse to be delivered, only with the sheet 2 of welding material when the second suction means are in the welding position WP, preserving the electronic component 1 from any electrical damage.

A support element 140 of the electronic component 1 is provided on the device 100 for gripping and welding according to the present invention, in particular at its terminal portion, i.e. the portion of the device 100 closer to the aforementioned welding plane (not shown). The first suction means are arranged within the aforesaid support element 140 in such a way as to define a cavity 141, or recess, able to house a portion 1A of the electronic component 1 not in contact, i.e. not directly retained, by the aforementioned first suction means. Usually, such portion 1A corresponds to the portion of the electronic component 1 wherein the circuitry is housed and which requires particular attention during handling to prevent damage. Furthermore, the support element 140 is provided with at least one pair of lateral walls 142 extending on planes orthogonal to the first area 111 for gripping the electronic component 1. This pair of lateral walls 142 is able to at least partially delimit the aforementioned first gripping area 111 for the support of the electronic component 1. Advantageously, this solution allows to mechanically delimit the position that the electronic component 1 can assume when collected by the device 100 for gripping and welding, defining a mechanical stop. Moreover, preferably, such gripping area 111 has at least one perimeter dimension substantially equal to that of the electronic component 1.

In the embodiment illustrated therein, the support element 140 has an inverted U-shaped configuration, i.e. able to define the opening of the cavity 141 facing the hypothetical welding plane. The U-shaped conformation therefore presents a symmetrical configuration also used to define a symmetry of arrangement of the first and second suction means. In such symmetrical U-shaped configuration, the support element 140 is provided with suitable protruding portions 143 defining the ends of the U-shaped configuration. Furthermore, the lateral walls 142 develop from the aforementioned protruding portions 143, completing the ends of the U-shaped conformation. In particular, the first suction means are arranged within said support element 140, so as to define the first gripping area 111 at the end surface of the protruding portions 143, whereas the aforementioned second suction means are developed within or at the pair of lateral walls 142, so as to define the second gripping area 121 at the end surface of the side walls 142. The aforementioned end surfaces being the surfaces closest to the hypothetical welding plane during the welding step.

According to further, not shown, embodiments both the first suction means and the second suction means could be arranged respectively at the aforementioned terminal portions or the aforementioned pair of side walls in an asymmetrical configuration. Furthermore, the symmetrical configuration of the first suction means and of the second suction means could also be obtained without the presence of the support element or with a support element having a different configuration from the U-shaped one.

In the embodiment shown therein, the first suction means preferably comprise a plurality of first suction ducts, collectively indicated as 112 in Figure 1, which define the aforementioned first gripping area 111 illustrated in Figure 1A. Moreover, the second suction means preferably comprise a plurality of second suction ducts, collectively indicated as 122 in the same Figure 1, which define the aforementioned second gripping area 121 illustrated in Figure 1A. Both the first suction ducts 112 and the second suction ducts 122 are configured to retain, during use, respectively, an electronic component 1 and a sheet 2 of welding material, exerting a negative pressure thereon or applying a suction force.

Preferably, the ducts 112, 122 are arranged in a symmetrical configuration on opposite sides of the terminal portion of the device 100 for gripping and welding, or of the support element 140, as described above. In particular, the plurality of first suction ducts 112 is arranged in a symmetrical configuration with respect to a symmetry axis (not shown) of the first gripping area 111. Likewise, the plurality of second suction ducts 122 is also arranged in a symmetrical configuration with respect to a symmetry axis (not shown) of the second gripping area 121.

Preferably, the first suction ducts 112 are at least two in number for each of the two opposite sides, so as to obtain a good retaining capacity of the electronic component 1. In particular, the device 100 for gripping and welding illustrated in the embodiment of Figures 1 and 1A comprises a number of first suction ducts 112 equal to six, which however does not define a limiting structure of the present invention, since a different number of ducts falls equally within the inventive concept. The aforementioned first suction ducts 112 are symmetrically arranged, three for each opposite side of the terminal portion.

In a further embodiment (not shown), while maintaining the same numbering and disposition on the two opposite sides of the terminal portion of the device for gripping and welding, the six first suction ducts could be arranged three for each opposite side but in alternate configuration or staggered according to a regular or irregular positioning structure.

The aforementioned first suction ducts 112 have the respective opening, defining the suction end, so as to be aligned on a single plane defining the first gripping area 111. In particular, the gripping area 111 is defined in such a way as to be parallel to the hypothetical welding plane when the device 100 performs the welding of the electronic component 1 on the substrate. This can be ensured by the arrangement at the same distance from the hypothetical welding plane of each opening of the first suction ducts 112. In the embodiment illustrated in Figure 1A, the first gripping area 111 does not correspond exclusively to the area occupied by the openings of the first suction ducts 112 but is extended on a hypothetical plane contiguous to the surface underlying said openings and such as to retain the electronic component 1. Thus, the openings of the first suction ducts 112 define, in part, the perimeter of the aforesaid first gripping area 111. A different arrangement of the first suction ducts and, consequently, of the respective suction ends can result in a different conformation of the relative first gripping area, even without changing the inventive concept.

In the embodiment illustrated therein, the opening of each of the first suction ducts 112 is aligned with respect to the protruding portions 143 of the support element 140 and, in particular, these openings are defined on the end surface of the aforementioned protruding portions 143. Therefore, preferably, the first suction ducts 112 are at least partially made as an integral part of the support element 140, e.g., by openings passing through it.

Preferably, also the second suction ducts 122 are at least two in number for each of the two opposite sides, so as to obtain a good retaining capacity of the sheet 2 of welding material. In particular, the device 100 for gripping and welding illustrated in the embodiment of Figures 1 and 1A comprises a number of second suction ducts 122 equal to four, which however does not define a limiting structure of the present invention, since a different number of ducts falls equally within the inventive concept. The aforementioned second suction ducts 122 are symmetrically arranged, two for each opposite side of the terminal portion. In particular, the second suction ducts 122 are arranged outside the first area 111 for gripping the electronic component 1.

In a further embodiment (not shown), while maintaining the same numbering and disposition on the two opposite sides of the terminal portion of the device 100 for gripping and welding, the second suction ducts could be arranged due for each opposite side but in alternate configuration or staggered according to a regular or irregular positioning structure.

The aforementioned second suction ducts 122 have the respective opening, defining the suction end, so as to be aligned on a single plane defining the second gripping area 121. In particular, the gripping area 121 is defined in such a way as to be parallel to the hypothetical welding plane when the device 100 performs the welding of the electronic component 1 on the substrate. This can be ensured by the arrangement at the same distance from the hypothetical welding plane of each opening of the second suction ducts 122. In the embodiment illustrated in Figure 1A, the second gripping area 121 does not correspond exclusively to the area occupied by the openings of the second suction ducts 122 but is extended on a hypothetical plane contiguous to the surface underlying said openings and such as to retain the sheet 2 of welding material. Thus, the openings of the second suction ducts 122 define, in part, the perimeter of the aforesaid second gripping area 121. A different arrangement of the second suction ducts and, consequently, of the respective suction ends can result in a different conformation of the relative second gripping area, even without changing the inventive concept.

In the embodiment illustrated therein, the second suction ducts 122 are defined by independent channels with respect to the support element 140 and arranged within the latter, i.e. within suitable through grooves. In particular, the second suction ducts 122 are arranged within the lateral walls 142 of the support element 140, thus resulting outside the first gripping area 111. The second suction ducts 122 are also aligned with respect to the end surfaces of the aforementioned lateral walls 142 so that in both the gripping positions GP and welding positions WP the suction ends result spaced apart by said end surfaces. This allows the second gripping area 121 to be arranged at a shorter distance from the welding plane with respect to the aforesaid first gripping area 121, in order to keep the sheet 2 of welding material in position below the electronic component 1. Finally, the alignment of the first suction ducts 121 and the second suction ducts 122, as described above, is such as to arrange the first gripping area 111 and second gripping area 121 for gripping on different but parallel planes, in turn parallel to the welding plane. This parallelism is preferably maintained also during the operations of gripping the electronic component 1 and the sheet 2 of welding material with respect to the relative lying planes.

The independent channels of the second suction ducts 122 are coupled to the support element 140 so as to be movable, or slidable, within the latter. In particular, each of the second suction ducts 122, i.e. of the independent channels, is operatively connected to suitable elastic means 123 for moving the suction ducts 122 between the gripping position GP and the welding position WP, and vice versa. The elastic means 123 are pre-tensioned to keep the suction ducts 122 in the gripping position GP allowing the suction ducts 122 to be arranged in the welding position WP when the second suction ducts 122 are subjected to pressure on a support, i.e. on the substrate wherein the welding is made.

In the embodiment shown in Figures 2-3B, the elastic means 123 are made by a plurality of springs, preferably of the helical type, each provided with an end connected to the respective second suction conduit 122. These are pre-tensioned in such a way that in their resting condition they dispose each suction duct 122 at the maximum axial extension with respect to the terminal portion of the device 100 for gripping and welding, i.e. respect to the support element 140, corresponding to the gripping position GP. During the deposition and welding step of the electronic component 1 and of the sheet 2 of welding material, the springs are compressed due to the arrangement of the second suction ducts 122 against the substrate which defines the hypothetical welding plane. The compression moves each suction duct 122 at the minimum axial extension with respect to the terminal portion of the device 100 for gripping and welding, i.e. respect to the support element 140, corresponding to the welding position WP. The springs also allow the automatic return to the resting configuration corresponding to the gripping position GP, thanks to the action of the aforementioned pre-tensioning.

The term "*axial extension*" means, in the present invention, the extension along an axis orthogonal to the hypothetical welding plane. In the embodiment illustrated therein, this axis is aligned with the major extension of the device 100 for gripping and welding.

The welding tip 130 preferably delivers the electrical impulse only when in contact with the sheet 2 of welding material, i.e. when the suction means are arranged in the aforementioned welding position WP. To obtain a correct welding it is important to determine both the pressure to be exerted with the electronic component 1 on the substrate and, therefore, on the sheet 2 of welding material, and the pressure that the welding tip 130 must exert on the sheet 2 of welding material. For this reason, it is very important to determine exactly the pre-tensioning of the springs or, in general, of the elastic means 123 in such a way that at the minimum axial extension the desired pressures are obtained. Alternatively, or in addition, it is possible to determine the desired pressure by moving the device 100 for gripping and welding only for a portion of the travel of the elastic means or to impart a greater pressure after reaching the minimum axial extension of the second suction means.

The elastic means 123 are further coupled to the opposite end with suitable fixed channels 124, an integral part of the second suction means and operatively connected with the second suction ducts 122 for retaining the sheet 2 of welding material.

The suction force, or negative pressure, exerted by the first suction ducts 112 and the second suction ducts 122 is obtained by connecting the first suction means and the second suction means to a single suction fitting 101, illustrated in Figures 4-6. Such connection to a single fitting 101 allows to reduce the costs and the dimensions of the device 100 for gripping and welding, by simultaneously placing the first suction ducts 112 as well as the second suction ducts 122, while in operating conditions, i.e. during suction step. Obviously, also the arrangement in the rest condition, or in the non-suction step, occurs simultaneously for both the plurality of suction ducts 112, 122.

According to an alternative embodiment, not shown, the first suction means are connected to a first suction fitting and the second suction means are connected to a second suction fitting. In particular, the first suction fitting and the second suction fitting are independent. In this case, the first suction ducts and the second suction ducts can be arranged in operating condition, that is during the suction step, both simultaneously and separately, according to the operating requirements for which the device for gripping and welding is used. The arrangement in the rest condition, that is not during the suction step, can also be carried out simultaneously for both the pluralities of suction ducts as well as separately, according to the operational requirements for which the device for gripping and welding is used.

The device 100 for gripping and welding described above is able to be§ coupled to an interface device 200 for defining an actuating head 10 for gripping and welding electronic components 1 of the Chip-On-Carrier type. Figures 5 and 6 illustrate an embodiment of the aforesaid actuating head 10 and the related interface device 200, described hereinafter in greater detail.

Figure 4 illustrates the device 100 for gripping and welding as previously described and further provided with the components necessary for the coupling with the aforesaid actuating head 10. In particular, the device 100 for gripping and welding illustrated in the embodiment of Figure 4 comprises a first mechanical interface pin 151, a second mechanical interface pin 152 and a first electrical interface pin 161.

According to further embodiments, not illustrated, the number of mechanical and electrical interface pins of the device for gripping and welding can vary and comprises at least one first mechanical interface pin and at least one first electrical interface pin.

The pair of mechanical interface pins 151, 152 allows to realize the mechanical connection between the device 100 and the interface 200, thus constituting the actuating head 10, while the electrical interface pin 161 allows to realize the electrical connection. In the aforesaid embodiment, the pins 151, 152, 161 define the end of the device 100 for gripping and welding to be connected to the actuating head 10 and are disposed at the opposite end defined by the support element 140 to be disposed, during use, at the hypothetical welding plane.

As illustrated in Figure 4, the end of the device 100 defined by the aforementioned pins 151, 152, 161 is connected to the end defined by the support element 140 by means of a support frame 150 interposed therebetween. In the present embodiment, the support frame 150 is defined by a bracket which has a U-shaped conformation, but further conformations are possible. The support element 140 is coupled at the lower portion of the U while the pair of mechanical interface pins 151, 152 and the electrical interface pin 161 is disposed at the opposite end of the side portions of the U, in particular with a mechanical interface pin 151, 152 for each lateral portion of the U.

Preferably, the aforesaid pins 151, 152, 161 have a cylindrical section with a tapered end portion 151", 152" to facilitate the coupling with an interface device 200 for defining an actuating head 10, described in greater detail in the following. Furthermore, the pair of mechanical interface pins 151, 152 has a central groove 151', 152' to facilitate locking of the aforementioned coupling.

The mechanical interface pins further have a through-opening 153, 154 (shown in section in Figure 6) that allows the suction means to be fed, integrating into a single element, i.e. the single interface pin 151, 152, both the mechanical connection and the pneumatic connection. This favours the rapidity of replacement of the device 100 for gripping and welding since connecting and disconnecting the mechanical interface pins 151, 152 is automatically realized or interrupted by both the mechanical coupling and the pneumatic coupling. Therefore, the through-openings 153, 154 define a portion of an air duct from which further flexible ducts, operatively connected with the first and/or second suction means, may depart.

In the embodiment described therein, provided with a single suction fitting 101 (of the flexible type) for feeding both the first suction means and the second suction means, the first mechanical interface pin 151 is not used for this purpose, while the second mechanical interface pin 152 is provided with the open end at the tapered end portion 152" and the opposite end connected to the aforementioned suction fitting 101.

The interface device 200 is illustrated as integrated in the assembly of the actuating head 10 of Figures 5 and 6. This interface device 200 makes it possible to make the operative connection to the device 100 for gripping and welding and to a possible robotic arm (not shown) able to move the aforesaid actuating head 10. The interface device 200 comprises a first mechanical interface connector 251, a second mechanical interface connector 252 and a first electrical interface connector (not shown).

Also in this case, according to further embodiments, not illustrated, the number of mechanical and electrical interface connectors of the interface device can vary and comprises at least one first mechanical interface pin and at least one first electrical interface pin.

The pair of mechanical interface connectors 251, 252 is able to couple with the respective mechanical interface pins 151, 152 of the device 100 for gripping and welding described previously. Likewise, the first electrical interface connector is able to be coupled with the first electrical interface pin 161 of the same device 100 for feeding the welding means 130.

In the embodiment illustrated in Figures 5 and 6, the connectors 251, 252 define the end of the interface device 200 to be connected to the device 100 for gripping and welding and are disposed at the opposite end defined by the coupling flange 201 with a robotic arm (not shown).

Preferably, the aforesaid connectors 251, 252 have a cylindrical section with a bevelled end portion to facilitate insertion of the tapered end portion 151 ",152" of the corresponding pins 151, 152. Further, the pair of mechanical interface connectors 251, 252 is provided with suitable locking means 251', 252' able to retain the mechanical interface pins 151, 152 in the correct locking position. This locking position corresponds, in particular, to the position in which the coupling between the central groove 151', 152' of the pins 151, 152 and a seal of the O-ring type provided on the connectors 251, 252 and such as to obtain the pneumatic seal.

Thus, the first mechanical interface connector 251 and/or the second mechanical interface connector 252 can be implemented between an operating position, in which the latter are respectively coupled to the first mechanical interface pin 151 and/or to the second mechanical interface pin 152, and a resting position, wherein these are respectively decoupled from the first mechanical interface pin 151 and/or from the second mechanical interface pin 152. In particular, the interface device 200 comprises an electric motor 230 operatively connected to the first mechanical interface connector 251 and/or to the second mechanical interface connector 252 modifying the mutual distance between said first connector and said second connector, as described below in more detail.

Analogously to what has been described for the aforesaid mechanical interface pins 151, 152, the mechanical interface connectors 251, 252 also have a through-opening 253, 254 (shown in section in Figure 6) for the pneumatic supply of the aforesaid pins 151, 152. This structure favours the quick replacement of the device 100 for gripping and welding with the automatic and simultaneous realization or interruption of the mechanical coupling and of the pneumatic coupling. Therefore, each pin-connector connection creates a suction fitting, which is operatively connected to the first suction means and/or to the second suction means and further operationally connected to suitable pneumatic means for feeding the aforementioned suction means. In particular, the first mechanical interface pin 151 and the first mechanical interface connector 251 have respective through-openings 153, 253 which define, when coupled, a first air duct for feeding the first suction means. Furthermore, the second mechanical interface pin 152 and the second mechanical interface connector 252 have respective through-openings 154, 254 which define, when coupled, a second air duct for feeding, e.g., the second suction means.

In the embodiment described therein, provided with a single suction fitting 101 for feeding both the first suction means and the second suction means, the first mechanical interface connector 251 is not used for this purpose, leaving only the mechanical interface second connector 252 for the pneumatic connection.

Preferably, moreover, the interface device 200 comprises compressed air feeding means 220 (shown partially in the form of a duct in Figure 6) and at least one Venturi device, operatively connected to the aforesaid compressed air feeding means 220 and, accordingly, to the first suction means and/or the second suction means. The Venturi device enables suction power to be obtained from the aforementioned first and second suction means by feeding compressed air in the Venturi device itself.

In the present invention, the term "*Venturi device*" means a device capable of generating negative pressure from the feed of a positive-pressure fluid. Such a device is, for example, provided with an inlet end and an outlet end for feeding a positive pressure fluid between which a narrowing is interposed at which a duct able to generate suction force is arranged, i.e. negative pressure, at the passage of said positive-pressure fluid.

As illustrated in Figure 6, the end of the interface device 200 defined by the aforementioned pins 251, 252 is disposed at the opposite end provided with the interface flange 201. A containment body 250 is interposed between said ends and is able to contain one or more elements of the actuating head 10 or a part thereof. For example, the interface device 200 comprises a control unit (not shown), preferably disposed inside said containment body 250. Such control unit is provided with at least one capacitor (not shown) capable of accumulating electrical energy, at least partly defining the circuit for actuating the welding means 130 of the device for gripping and welding, as described above. Furthermore, also the electrical engine 230 is preferably housed within the interface device 200 and is operatively connected to the first interface connector 251 and/or to the second interface connector 252 by means of a rack 231, also disposed within the containment structure 250. In order to maintain the required work environment safety, the electric motor 230 is of the low voltage type, preferably 24V powered. On the electric motor 230 a position encoder is installed, which advantageously makes it possible to determine with high precision the angle of rotation of its shaft, and/or its speed of rotation. In detail, the rotation of the electric motor 230 determines the axial displacement of the rack 231 and the consequent movement towards or away from of one or both of the mechanical interface connectors 251, 252. Clearance recovery means can also be present, comprising preferably but in a non-limiting way a compensating spring.

According to a further embodiment, not illustrated, the interface device may be provided with a pair of racks in order to ensure symmetry of movement of both the mechanical interface connectors.

The handling of the mechanical interface connectors 251, 252 advantageously allows to adjust the pitch between these and the associated mechanical interface pins 151, 252, or to modify the mutual distance between said first connector and said second connector as a function of the reciprocal distance between the first mechanical interface pin and the second mechanical interface pin. In this way, it is possible to obtain a high degree of flexibility in terms of connection capacity with different devices for gripping and welding provided with mechanical interface pins with different mutual spacings, adapting the actuating head to the requirements determined by the type of application or components to be moved and welded. The pitch adaptation can be advantageously carried out through an automatic procedure by using the position encoder installed on the electric motor 230.

The actuating head 10 of gripping and welding of electronic components 1 of the Chip-On-Carrier type described above is able to be coupled to a robotic arm (not shown), provided with an end comprising a housing flange for connection with the aforementioned coupling flange 201, defining a robot for gripping and welding electronic components 1 of the Chip-On-Carrier type. Preferably, the robot for gripping and welding further comprises a computerized and programmable data processing unit (not shown) able to control the movement of the robotic arm and/or of the actuating head 10 for gripping and welding and/or the device 100 for gripping and welding. Preferably, this data processing unit is able to control the control unit of the interface device 200 for actuating the welding means 130 of the device 100 for gripping and welding. Even more preferably, the aforesaid data processing unit can determine the movement of the actuating head 10 along a first axis, perpendicular to the lying plane and/or to the welding plane of the electronic components 1 and of the sheets 2 of welding material. Further, the data processing unit can determine the movement of the aforesaid actuating head 10 also along a second axis, parallel to the aforesaid lying and welding planes, in a movement that can also be composed with the movement along the first axis.

Through the previously described device 100 for gripping and welding, object of the present invention, it is possible to realize a method for gripping and welding electronic components 1 of the Chip-On-Carrier type, as described below. The same process steps can also be carried out when the aforementioned device 100 for gripping and welding is an integral part of an actuating head 10 for gripping and welding and/or when the same is an integral part of a robot for gripping and welding.

Advantageously, the use of a device 100 for gripping and welding according to the present invention allows to obtain an optimum and homogeneous welding precision, avoiding the risks connected with anomalous movement of the electronic component 1 and of the sheet 2 of welding material, as well as possible excessive heating during the welding step.

The above-mentioned method comprises the steps described in the following, preferably in the identified sequence. It is hypothesized that the electronic element 1 and the sheet 2 of welding material are arranged on the same lying plane in two different locations, e.g. a store (plane or vertical) of electronic elements 1 and a store (plane or vertical) of sheets 2 of welding material. The electronic component 1 consists, e.g., of an emitting diode and the sheet 2 of welding material consist, e.g. of a multilayer sheet providing a high instant heating when activated by a small impulse of electrical energy. A plurality of electrical components 1 are thus assembled according to a predetermined conformation on a single substrate, e.g. an emitting package with multiple elements. The electronic components 1 are assembled on said substrate by the welding of a plurality of sheet 2 of welding material, a sheet for each component.

At a first step, the electronic component 1 is withdrawn within a first gripping area 111 by the first suction means. The electrical component 1 is withdrawn by arranging the aforementioned suction means, or the gripping area 111, at the electrical components 1 store or at a location thereof defining a second gripping position. The withdrawn electrical component 1 is, therefore, retained within the gripping area 111, continuing with the subsequent steps. The withdrawing and retention of the electrical component 1 within the aforesaid gripping area 111 is achieved by generating and using negative pressure, or suction, by means of the first suction means, as described previously.

Advantageously, the electronic component 1 can be retained by means of a suitable support element 140 so as to guarantee its positioning accuracy in a subsequent step. In particular, the support element 140 may allow a positioning and alignment step of at least one of its perimeter portions with at least one perimeter portion of the electronic component 1, to ensure correct handling and correct alignment thereof.

In a subsequent step, a sheet 2 of welding material is withdrawn within a second gripping area 121 by second suction means. The sheet 2 of welding material is withdrawn by arranging said second suction means, or the second gripping area 121, at the store of the sheets 2 or at a location thereof defining a second gripping position. The removed sheet 2 of welding material is, therefore, retained within the second gripping area 121, continuing with the subsequent steps. The withdrawing and retention of the sheet 2 of welding material within the aforesaid second gripping area 121 is achieved by generating and using negative pressure, or suction, by means of the second suction means, as described previously. In particular, the sheet 2 of welding material is disposed in the gripping position GP spaced from the electronic component 1, according to the above description.

The activation of the first and second suction means is preferably obtained simultaneously, even if the respective steps of the method involving said means result as sequential.

The completion of the collection and retention steps enables at such point to maintain the electronic component 1 and the sheet 2 of welding material in an overlapped and spaced position.

Subsequently, a step of arranging the electronic component 1 and the sheet 2 of welding material at a support of the electronic component 1 allows maintaining the simultaneous retention of the aforementioned electronic component 1 and of the aforementioned sheet 2 of welding material. This allows the electronic component 1 to be correctly oriented with respect to the required position on the substrate. For example, an emitter diode may be aligned on the substrate in such a way as to orient the emitted light beam in a predetermined direction with respect to the substrate.

The second suction means are then moved for the step of depositing the sheet 2 of welding material in the welding position WP from the preceding gripping position GP. This allows the sheet 2 of welding material to be placed in contact on the substrate and the electronic component 1 to be retained by the first suction means. To allow movement between the gripping position GP at the welding position WP of the sheet 2 of welding material, the device 100 for gripping and welding is pressed against the surface of the substrate, exploiting the elastic means 123 for obtaining the movement of the second welding means.

Following the deposition, the step of welding the electronic component 1 on the support by melting the sheet 2 of welding material is carried out by means of suitable welding means 130 able to deliver an electrical impulse for melting the sheet 2 of welding material. The welding step is carried out by exerting a predetermined pressure of the electronic component 1 and of the sheet 2 of welding material on the support, in order to obtain a correct welding. The electric impulse is delivered near the perimeter of the electronic component 1 on the contact surface of the sheet 2 of welding material. This causes the activation of the reactive material contained in the sheet 2 of welding material with consequent fusion of the same and welding of the electronic component 1 to the substrate. Therefore, the pressure that the welding tip 130 must exert on the sheet 2 of welding material is further important. For this reason, it is necessary to accurately determine the pre-tensioning value of the springs or, in general, of the elastic means 123 in such a way that the desired pressures are obtained at the minimum axial extension.

Preferably, the electric pulse is delivered near the perimeter of the electronic component 1.

Advantageously, to avoid excessive heating also of the electronic component 1, the electric impulse is delivered within a few milliseconds. Preferably, such time span is less than 10 milliseconds, preferably between 2 and 8 milliseconds, and even more preferably equal to 5 milliseconds. This advantageously allows the complete activation of the sheet 2 of welding material without wasting electrical energy and without damaging the components. The duration and/or intensity of the pulse may be different depending on the welding materials used for the melting of the aforementioned sheet 2 of welding material.

Finally, a last step consists in releasing the electronic component 1 and the sheet 2 of welding material coupled on the support. At this point, by cancelling the effect of the negative pressure applied by means of the first suction ducts 112, the electronic component 1 is released by terminating the application of the electronic component 1 taken from the store.

The device 100 for gripping and welding can then be moved again to start a new cycle with the step of collecting and retaining a new solar cell 1, preferably from the aforementioned first gripping position of the relative store.

The control of the movement of the device 100 for gripping and welding and/or of the actuating head 10 of which the aforementioned device 100 is part can be performed by a data processing unit, for example the data processing unit of a robot, which performs a stored process according to appropriate instructions in suitable storage means, preferably of the non-volatile type. For example, the method described above could be coded as a sequence of instructions inside a data processing unit.

The device for gripping and welding can be made for the dimensions of a specific electronic component 1 or for a specific application substrate. Therefore, a plurality of devices for gripping and welding can be made according to the applications to be implemented. In this case, the coupling of one of the devices for gripping and welding with the interface device for the realization of an actuating head for gripping and welding is obtained, as described previously, by means of the coupling between the mechanical and electrical interface pins and mechanical and electrical interface connectors, in which the connectors provided on the interface device can be moved axially with respect to the aforementioned pins. This, advantageously, allows to adapt the differences in pitch that may exist between different interface pins and therefore allows the actuating head to work with a high flexibility in terms of connection capacity with different gripping devices. The adaptation of the pitch is advantageously carried out through an automatic procedure thanks to the presence of the position encoder installed on the electric motor. In particular, this automatic procedure is performed upstream of the first step described above for the method according to the present invention.

## Claims

1. A device (100) for gripping and welding electronic components (1) of the Chip-On-Carrier type on a support of said electronic components (1), comprising:
- first suction means able, during use, to retain said electronic component (1) and defining a first gripping area (111) for said electronic component (1);
- second suction means able, during use, to retain a sheet (2) of welding material and defining a second gripping area (121) for said sheet (2) of welding material, said second suction means being disposed outside said first gripping area (111) of said electronic component (1), and
- welding means (130) of said sheet (2) of welding material, able, during use, to deliver an electrical impulse for melting said sheet of welding material;
wherein said first gripping area (111) of said electronic component (1) and said second gripping area (121) of said sheet (2) of welding material are arranged on different and parallel planes, and
wherein said second suction means are movable between a gripping position (GP), wherein said second suction means retain said sheet (2) of welding material spaced from said electronic component (1) retained by said first suction means, and a welding position (WP), wherein said second suction means retain said sheet (2) of welding material at said support and in contact with said electronic component (1) held by said first suction means during the delivery of the electrical impulse from said welding means (130).

2. The device (100) for gripping and welding according to claim 1, wherein said welding means (130) are interposed between said first suction means and said second suction means, when said second suction means are arranged in said gripping position (GP).

3. The device (100) for gripping and welding according to claim 1 or 2, comprising a support element (140) of said electronic component (1), wherein said first suction means are arranged in said support element (140) in such a way as to define a cavity (141) able to house a portion (1A) of said electronic component (1) not in contact with said first suction means.

4. The device (100) for gripping and welding according to claim 3, wherein said support element (140) is provided with at least a pair of side walls (142) extending on planes orthogonal to said first gripping area (111) of said electronic component (1), said pair of side walls (142) being able to at least partially delimit said first gripping area (111) for said support of said electronic component (1)

5. The device (100) for gripping and welding according to one or more claims from 1 to 4, wherein said first suction means comprise a plurality of first suction ducts (112) and the second suction means comprise a plurality of second suction ducts (122).

6. The device (100) for gripping and welding according to claim 5, wherein said plurality of first suction ducts (112) is arranged in a symmetrical configuration with respect to a symmetry axis of said first gripping area (111) and said plurality of second suction ducts (122) is arranged symmetrically with respect to a symmetry axis of said second gripping area (121).

7. The device (100) for gripping and welding according to claim 4 or 5, comprising elastic means (123) operatively connected to said plurality of second suction ducts (122) for moving said plurality of second suction ducts (122) between said gripping position (GP) and said welding position (WP), and vice versa,
wherein said elastic means (123) are pre-tensioned to maintain said second suction ducts (122) in said gripping position (GP) and allowing said second suction ducts (122) to be placed in said welding position (WP) when said second ducts (122) are subjected to a pressure on a support.

8. The device (100) for gripping and welding according to one or more claims from 1 to 7, wherein said first suction means and said second suction means are connected to a single suction fitting (101).

9. The device (100) for gripping and welding according to one or more claims from 1 to 7, wherein said first suction means are connected to a first suction fitting and said second suction means are connected to a second suction fitting independent from said first suction fitting.

10. An actuating head (10) for a robotic arm for gripping and welding electronic components (1) of the Chip-On-Carrier type, comprising:
- a device (100) for gripping and welding electronic components (1) of the Chip-On-Carrier type on a support, according to one or more claims from 1 to 9;
- an interface device (200) provided with a coupling flange (201) for said robotic arm and able to operatively connect said device (100) for gripping and welding to said robotic arm;
wherein said device (100) for gripping and welding comprises at least a first mechanical interface pin (151) and at least a first electrical interface pin (161),
wherein said interface device (200) comprises at least a first mechanical interface connector (251), able to be coupled with said first mechanical interface pin (151), and at least a first electrical interface connector, able to be coupled with said first electric interface pin (161) for feeding said welding means,
wherein said first mechanical interface pin (151) and said first mechanical interface connector (251) respectively have a through opening (153, 253) which, when coupled, defines a first air duct for feeding said first suction means and/or said second suction means, and
wherein said interface device (200) comprises a control unit provided with at least one capacitor for the energy storage for activating said welding means (130) of said device (100) for gripping and welding.

11. The actuating head (10) according to claim 10, wherein said device (100) for gripping and welding comprises a first mechanical interface pin (151) and a second mechanical interface pin (152),
wherein said interface device (200) comprises a first mechanical interface connector (251) and a second mechanical interface connector (252),
wherein said first mechanical interface pin (151) and said first mechanical interface connector (251) respectively have a through opening (153, 253) which, when coupled, defines a first air duct for feeding said first suction means, and
wherein said second mechanical interface pin (152) and said second mechanical connector (252) respectively have a through opening (154, 254) which, when coupled, defines a second air duct for feeding said second suction means.

12. The actuating head (10) according to claim 10 or 11, wherein said interface device (200) comprises compressed air feeding means (220) and at least one Venturi device, operatively connected to said compressed air feeding means (220) and to said first suction means and/or to said second suction means, to obtain suction force to said first suction means and/or to said second suction means through the feeding of compressed air into said Venturi device.

13. The actuating head (10) according to one or more claims from 10 to 12, wherein said first mechanical interface connector (251) and/or said second mechanical interface connector (252) are actuatable between an operating position, wherein are respectively coupled to said first mechanical interface pin (151) and/or to said second mechanical interface pin (152), and a resting position, wherein are respectively decoupled from said first mechanical interface pin (151) and/or from said second mechanical interface pin (152), and
wherein said interface device (200) comprises an electric motor (230) operatively connected to said first mechanical interface connector (251) and/or said second mechanical interface connector (252) to modify the mutual distance between said first connector (251) and said second mechanical interface connector (252).

14. A robot for gripping and welding electronic components (1) of the Chip-On-Carrier type comprising:
- an actuating head (10) for gripping and welding electronic components (1) of the Chip-On-Carrier type on a support, according to one or more claims from 10 to 13;
- a robotic arm provided with an end comprising a housing flange for said coupling flange (201);
- a computerized and programmable data processing unit able to control the movement of said robotic arm and/or of said actuating head (10) for gripping and welding;
wherein said data processing unit is able to control said control unit of said interface device (200) for actuating said welding means (130) of said device (100) for gripping and welding.

15. A method for gripping and welding electronic components (1) of the Chip-On-Carrier type on a support, comprising the steps of:
- collecting and retaining said electronic component (1) within a first gripping area (111), by means of first suction means;
- collecting and retaining a sheet (2) of welding material within a second gripping area (121), by means of second suction means, wherein said sheet (2) of welding material is arranged in a gripping position (GP) spaced from said electronic component (1);
- arranging said electronic component (1) and said sheet (2) of welding material at a support of said electronic component (1) while maintaining the retention of said electronic component (1) and of said sheet (2) of welding material;
- depositing said sheet (2) of welding material in a welding position (WP), by moving said second suction means, wherein said sheet (2) of welding material is arranged on said support in contact with said electronic component (1) retained by said first suction means;
- welding said electronic component (1) on said support by melting said sheet (2) of welding material, by welding means (130) able to deliver an electrical impulse for melting said sheet (2) of welding material, exerting a predetermined pressure of said electronic component (1) and of said sheet (2) of welding material on said support;
- release said electronic component (1) and said sheet (2) of welding material coupled on said support.
